# EUROPEAN PATENT APPLICATION

(11) **EP 2 453 043 A1**
(43) Date of publication of application: **16.05.2012**
(21) Application number: 10797037.8
(22) Date of filing: 28.06.2010
(51) Int. Cl.: C30B 29/38, C23C 16/01, C30B 25/20

(54) **METHOD OF MANUFACTURING NITRIDE SEMICONDUCTOR SUBSTRATE**

(30) Priority: 07.07.2009 JP 2009161023
(71) Applicant: Sumitomo Electric Industries, Ltd., Chuo-ku Osaka-shi Osaka 541-0041 (JP)
(72) Inventor: OSADA, Hideki, Itami-shi Hyogo 664-0016 (JP); UEMATSU, Koji, Itami-shi Hyogo 664-0016 (JP); NAKAHATA, Seiji, Itami-shi Hyogo 664-0016 (JP); NAKANISHI, Fumitake, Itami-shi Hyogo 664-0016 (JP)
(74) Representative: Grünecker, Kinkeldey, Stockmair & Schwanhäusser
(86) International application number: PCT/JP2010/060962
(87) International publication number: WO 2011/004726

(57) **Abstract**

The invention provides a method of manufacturing a nitride semiconductor substrate capable of efficiently manufacturing a nitride semiconductor substrate having a nonpolar plane as a major surface in which polycrystalline growth is minimized. A method of manufacturing a GaN substrate, which is a nitride semiconductor substrate, includes steps (S10 and S20) of preparing a starting substrate composed of GaN and having a major surface with an off-axis angle of between 4.1° and 47.8° inclusive with respect to a {1-100} plane, a step (540) of epitaxially growing a semiconductor layer made of GaN on the major surface of the starting substrate, and a step (S50) of picking out a GaN substrate having an *m* plane as the major surface from the semiconductor layer.

## Description

### Technical Field

The present invention relates to methods of manufacturing nitride semiconductor substrates, and more specifically relates to a nitride semiconductor substrate manufacturing method enabling the efficient manufacture of a nitride semiconductor substrate having a nonpolar plane as the major surface.

### Background Art

A nitride semiconductor substrate made of a nitride semiconductor such as GaN (gallium nitride) is used in the manufacture of semiconductor devices such light emitting elements (for example, light emitting diodes and laser diodes). The just-noted semiconductor substrate can be manufactured efficiently by growing crystal with a {0001} as the growth plane and slicing the crystal along the {0001} plane. For this reason, the major surface of a nitride semiconductor substrate such as a GaN substrate is generally a {0001} plane.

However, in a case in which, for example, semiconductor devices are manufactured by forming a semiconductor layer such as InGaN (indium gallium nitride) onto a GaN substrate major surface whose plane orientation is {0001}, a problem that can arise is that the essentially expected properties cannot be obtained, on account of the occurrence of piezoelectric fields.

Against this backdrop, the adoption of nitride semiconductor substrates that have a {1-100} plane or a {11-20} plane, which are nonpolar planes, as the major surface has been under investigation lately, with the objective of eliminating the above-described problem originating in piezoelectric fields. A proposed method for efficiently manufacturing a nitride semiconductor substrate with a nonpolar plane as the major surface is that of cutting out a starting substrate with a nonpolar plane as the major surface from a crystal grown with a {0001} growth plane, growing crystal with a nonpolar plane as the growth plane, and then slicing the crystal along the nonpolar plane (see, for example, see PTL 1).

### Citation List

### Patent Literature

PTL 1 Japanese Unexamined Pat. App. Pub. No. 2008-143772

### Summary of Invention

### Technical Problem

However, in the case in which a crystal is grown with a {1-100} plane or a {11-20} plane as the growth plane, the growth surface is prone to becoming supersaturated, and polycrystalline regions where polycrystal has grown tend to form. In situations where polycrystalline regions have formed, it is necessary to pick out substrates so that such regions are not included. An additional problem that can arise is of cracks occurring in the crystal, starting from such regions as the origin.

Given the above, an object of the present invention is to make available a nitride semiconductor substrate manufacturing method that enables the efficient manufacture of nitride semiconductor substrates having a nonpolar plane as the major surface, by controlling to a minimum the polycrystalline growth discussed above.

### Solution to Problems

One embodying mode of a method of manufacturing a nitride semiconductor substrate according to the present invention comprises a step of preparing a starting substrate made of a nitride semiconductor and having a major surface with an off-axis angle that is between 4.1° and 47.8° inclusive with respect to a {1-100} plane, a step of epitaxially growing a semiconductor layer made of a nitride semiconductor on the major surface of the starting substrate, and a step of picking out from the semiconductor layer a nitride semiconductor substrate having an *m* plane as the major surface.

In the above-described one aspect of the manufacturing method, a process is adopted in which a substrate having a major surface with an off-axis angle of between 4.1° and 47.8° inclusive with respect to a {1-100} plane is adopted as the starting substrate, and a semiconductor layer is grown onto the major surface. For this reason, in growing the semiconductor layer, the appearance of {1-100} planes in the major growth plane (growth plane parallel to the major surface) of the starting substrate is minimized. Doing so keeps the semiconductor layer from growing as polycrystal. Also, nitride semiconductor substrates having the *m* plane as the major surface can be efficiently picked out from a semiconductor layer in which polycrystalline growth has been controlled to a minimum. According to this aspect of a method for manufacturing a nitride semiconductor substrate according to the present invention in this manner, it is possible to minimize polycrystalline growth, and to efficiently manufacture a nitride semiconductor substrate having a nonpolar plane as the major surface.

If a starting substrate having a major surface with an off-axis angle of less than 5.1° with respect to a {1-100} plane (an off-axis angle exceeding 84.9° with respect to a {0001} plane) is employed, {1-100} planes appear in the major growth plane, such that polycrystalline growth regions occur in the semiconductor layer. Also, in the case in which the off-axis angle with respect to a {1-100} plane is less than 5.1 °, rather than a plane that is parallel to the major surface of the starting substrate, the proportional ratio (m plane growth proportion) of occupation of the semiconductor layer by the region grown with a {1-100} plane as a growth plane (m-plane growth portion) becomes large, and the required diameter of the semiconductor layer for picking out a nitride semiconductor substrate of the desired diameter becomes excessively large. Therefore, the above-noted off-axis angle is preferably 5.1° or greater and, considering the precision of slicing and the like, the above-noted off-axis angle is preferable made 4.1° ° or greater.

In contrast, if a starting substrate is selected having a major surface with an off-axis angle exceeding 46.8° with respect to a {1-100} plane (an off-axis angle smaller than 43.2° with respect to a {0001} plane) the required thickness of the semiconductor layer for picking out a nitride semiconductor substrate having the *m* plane as the major surface becomes so large as to exceed the allowable limit for the actual manufacturing process, and is unrealistic. Also, if the off-axis angle with respect to a {1-100} plane exceeds 46.8°, in the major growth plane, there will be a mixed presence of planes with an off-axis angle of 62° or smaller with respect to the c plane. A region that has grown with a plane having, with respect to the c plane, an off-axis angle of 62° or smaller as its growth plane will have an amount of captured oxygen that is smaller than that of the other regions, and the electrical resistance of the region will be large. As a result, a distribution of electrical resistance occurs within the plane of the substrate that is obtained. Therefore, the above-noted off-axis angle is preferably 46.8° or smaller and, considering the precision of slicing and the like, the above-noted off-axis angle is preferably made 47.8° or smaller.

A nitride semiconductor substrate according to the present invention is specifically a substrate made of a chemical compound of a IIIB group element and nitrogen.

A nitride semiconductor substrate having an *m* plane as the major surface is a nitride semiconductor substrate in which the major surface is substantially the *m* plane (a {1-100} plane), and more specifically, a nitride semiconductor substrate in which the off-axis angle of the major surface with respect to a {1-100} plane is ±2° or smaller in the *a-*axis direction and also ±2° or smaller in the c-axis direction.

In the above-noted aspect of a method of manufacturing a nitride semiconductor substrate, it is preferable that the major surface of the starting substrate have an off-axis angle with respect to a {1-100} plane of 9.1° or greater and 20.5° or smaller.

By doing this, it is possible to minimize the occurrence of polycrystalline regions in the semiconductor layer all the more reliably. It is also possible to make the thickness required of the semiconductor layer even smaller, while further avoiding the diameter required of the semiconductor layer becoming excessively large.

Another embodying mode of a method for manufacturing a nitride semiconductor substrate according to the present invention comprises a step of preparing a starting substrate made of a nitride semiconductor and having a major surface with an off-axis angle of between 4.8° and 43.7° inclusive respect to a {11-20} plane, a step of epitaxially growing a semiconductor layer made of a nitride semiconductor onto the major surface of the starting substrate, and a step of picking out from the semiconductor layer a nitride semiconductor substrate having an a plane as the major surface.

The above-noted other aspect of the method for manufacturing adopts the process of using as a starting substrate a substrate having a major surface with an off-axis angle of between 4.8° and 43.7° inclusive with respect to a {11-20} plane and growing a semiconductor layer on the major surface. For this reason, in the growth of the semiconductor layer, the appearance of a {11-20} plane in the major growth plane of the starting substrate (growth plane parallel to the major surface) is minimized, to keep the semiconductor layer from growing as polycrystal. In addition, nitride semiconductor substrates having the *a* plane as the major surface can be efficiently picked out from the semiconductor layer in which polycrystalline growth has been controlled to a minimum. According to this other aspect of a method of manufacturing a nitride semiconductor substrate according to the present invention in this manner, it is possible to minimize polycrystalline growth, and to efficiently manufacture a nitride semiconductor substrate having a nonpolar plane as the major surface.

If the starting substrate is selected having a major surface with an off-axis angle of less than 5.8° with respect to a {11-20} plane (an off-axis angle exceeding 84.2° with respect to a {0001} plane), a {11-20} plane appears in the major growth plane, and polycrystalline growth occurs in the semiconductor layer. Also, in the case in which the off-axis angle with respect to a {11-20} plane is less than 5.8°, rather than a plane that is parallel to the major surface of the starting substrate, the proportional ratio (*a*-plane growth proportion) of occupation of the semiconductor layer by a region in which there is growth with a {11-20} plane as the growth plane (*a*-plane growth portion) becomes large, and the required diameter of the semiconductor layer for picking out a nitride semiconductor substrate of the desired diameter becomes excessively large. Therefore, the above-noted off-axis angle is preferably 5.8° or greater and, considering the precision of slicing and the like, the above-noted off-axis angle is preferable made 4.8° or greater.

In contrast, if a starting substrate is selected having a major surface with an off-axis angle exceeding 42.7° with respect to a {11-20} plane (an off-axis angle smaller than 47.3° with respect to a {0001} plane), the required thickness of the semiconductor layer for picking out a nitride semiconductor substrate having the *a* plane as the major surface becomes so large as to exceed the allowable limit for the actual manufacturing process, and is unrealistic. Also, if the off-axis angle with respect to a {11-20} plane exceeds 42.7°, in the major growth plane there will be a mixed presence of planes with an off-axis angle of 62° or smaller with respect to the c plane. As stated earlier, a region that has grown with, as its growth plane, a plane having an off-axis angle of 62° or smaller with respect to the c plane will have an amount of captured oxygen that is smaller than that of the other regions, and the electrical resistance of the region will be large. As a result, a distribution of electrical resistance occurs within the plane of the substrate that is obtained. Therefore, the above-noted off-axis angle is preferably 42.7° or smaller and, considering the precision of slicing and the like, the above-noted off-axis angle is preferably made 43.7° or smaller.

A nitride semiconductor substrate having the *a* plane as the major surface is a nitride semiconductor substrate in which the major surface is substantially the *a* plane (a {11-20} plane), and more specifically, a nitride semiconductor substrate in which the off-axis angle of the major surface with respect to a {11-20} plane is ±2° or smaller in the m-axis direction and also ±2° or smaller in the c-axis direction.

In the above-noted other aspect of a method of manufacturing a nitride semiconductor substrate, it is preferable that the major surface of the starting substrate have an off-axis angle with respect to a {11-20} plane of 7.7° or greater and 32.6° or smaller.

Doing this further makes it possible to keep polycrystalline regions from occurring in the semiconductor layer. It is also possible to make the thickness required of the semiconductor layer even smaller, while further avoiding the diameter required of the semiconductor layer becoming excessively large.

In the above-noted method of manufacturing a nitride semiconductor substrate, in the step of preparing the starting substrate, a plurality of starting substrates may be prepared, and in the step of epitaxially growing the semiconductor layer, a semiconductor layer may be epitaxially grown on the major surfaces of the plurality of starting substrates, disposed in such a way that corresponding lateral surfaces thereof oppose each other. By doing this, it is easy to manufacture a large-diameter nitride semiconductor substrate.

### Advantageous Effects of Invention

As is clear from the foregoing description, the method of manufacturing a nitride semiconductor substrate of the present invention is capable of efficiently manufacturing a nitride semiconductor substrate having a nonpolar plane as the major surface.

### Brief Description of the Drawings

Fig. 1 is a flowchart showing the outline of a method of manufacturing a nitride semiconductor substrate according to the present invention.
Fig. 2 is a simplified perspective view for describing a method of manufacturing a nitride semiconductor substrate according to the present invention.
Fig. 3 is a simplified cross-sectional view for describing a method for manufacturing a nitride semiconductor substrate according to the present invention.
Fig. 4 is a simplified cross-sectional view for describing a method for manufacturing a nitride semiconductor substrate according to the present invention.
Fig. 5 is a simplified cross-sectional view for describing a method for manufacturing a nitride semiconductor substrate according to a second embodying mode of the present invention.

### Description of Embodiments

Embodying modes of the present invention are described below, based on accompanying drawings. In the drawings referenced below, elements that are the same or corresponding elements are assigned the same reference numerals, and their descriptions are not repeated.

### Embodying Mode 1

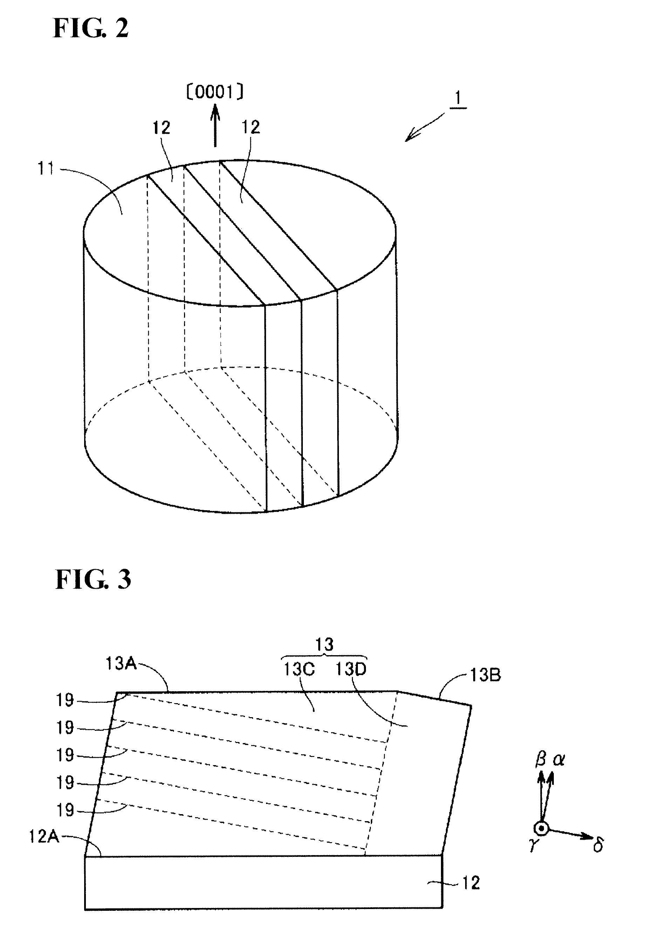

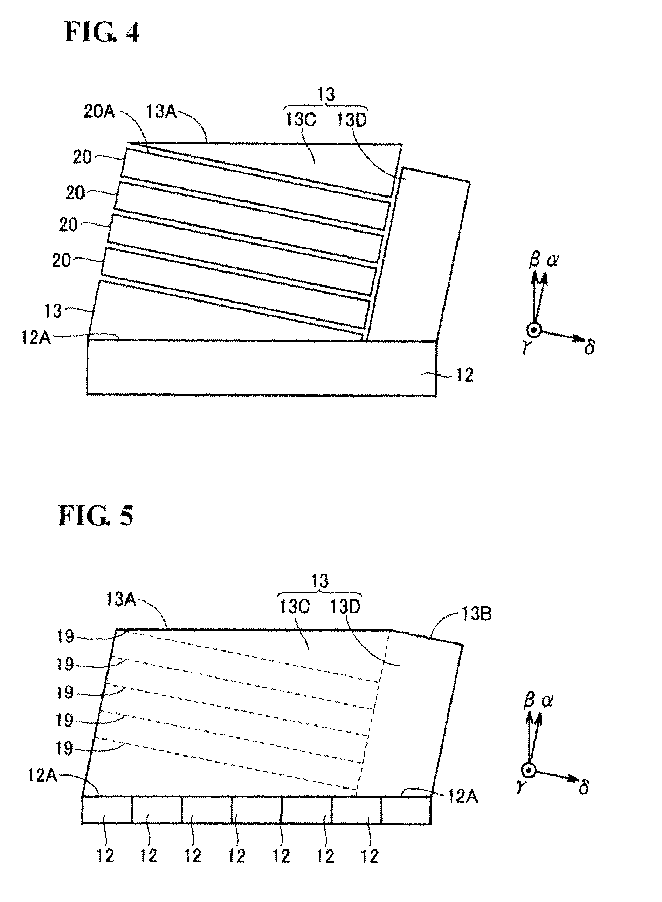

First, with regard to Embodying Mode 1, being a first mode of embodying the present invention, a method of manufacturing a GaN substrate, which is a nitride semiconductor substrate, will be described as an example. In Embodying Mode 1, in Fig. 3 and Fig. 4, α indicates the [1-100] direction, β indicates, for example, the [20-21] direction, γ indicates the [11-20] direction, and δ indicates the [0001] direction.

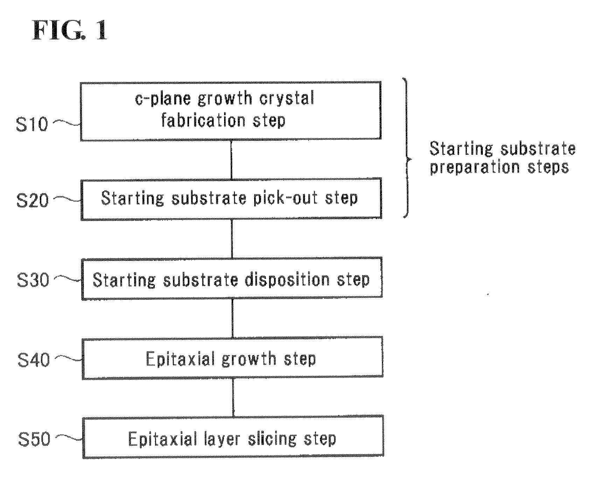

Referring to Fig. 1, in the method of manufacturing a GaN substrate of Embodying Mode 1, a c-plane growth crystal fabrication step is performed as the step S10. In this step S10, as shown in Fig. 2, a growth process such as HVPE (hydride vapor phase epitaxy) is used to fabricate a GaN crystal 1 having a {0001} plane (c plane) as the growth plane 11. The fabrication of this GaN crystal 1 may be done by a process other than HVPE, for example, by a flux method, an ammonothermal method, or by a liquid layer growth method.

Next, referring to Fig. 1, a starting substrate pick-out step is performed as step S20. In this step S20, as shown in Fig. 2, by slicing the GaN crystal 1 fabricated in step S10, the starting substrate 12 is picked out. In picking out the starting substrate 12 herein, a starting substrate 12 is picked so as to have a major surface with an off-axis angle of between 4.1° and 47.8° inclusive with respect to a {1-100} plane. In this manner, adopting a process whereby a GaN crystal 1 is fabricated by employing the c plane as the growth plane and growing the crystal at a high growth rate, and thereupon the GaN crystal 1 is sliced to pick out a starting substrate 12, makes it possible to efficiently obtain starting substrates 12. The above-noted steps S10 and S20 constitute the starting substrate preparation process.

Next, referring to Fig. 1, the starting substrate disposition process is performed as step S30. In this step S30, the starting substrate 12 picked out in step S20 is disposed, for example, in a HVPE apparatus, to enable exposure of the major surface to precursor gases.

Next, referring to Fig. 1, epitaxial growth is done as step S40. At this step S40, as shown in Fig. 3, an epitaxial growth layer 13 is grown by an HVPE process as a semiconductor layer made of GaN on the major surface 12A of the starting substrate 12 that was disposed within an HVPE apparatus at step S30. When this is done, the epitaxial growth layer 13 includes a first growth region 13C grown with the first growth plane 13A (major growth plane) that is parallel to the major surface 12A of the starting substrate 12 as its growth plane, and a second growth region 13D having an m-plane growth portion that is grown with the second growth plane 13B, which is a plane {1-100}, as its growth plane.

Next, referring to Fig. 1, an epitaxial layer slicing step is performed as step S50. By this step S50, as shown in Fig. 3 and Fig. 4, of the epitaxial growth layer 13 formed by step S40, by slicing the first growth region 13C on the slicing plane 19 along the *m* plane, it is possible to obtain a GaN substrate 20 in which the major surface 20A is the *m* plane. By the above procedure, it is possible to manufacture a GaN substrate 20 of this embodying mode.

In the method of manufacturing a GaN substrate in the above-noted embodying mode, as described above, the off-axis angle of the major surface 12A of the starting substrate 12 is 4.1° or greater with respect to a {1-100} plane. For this reason, in the first growth plane 13A that is parallel to the major surface 12A of the starting substrate 12, the appearance of {1-100} planes is minimized. As a result, in the first growth region 13C grown with the first growth plane 13A as the growth plane in step S40, polycrystalline growth is minimized to keep the occurrence of polycrystalline regions under control. It is also possible to grow at a high growth rate. Additionally, the proportion of the epitaxial growth layer 13 that is occupied by the second growth region 13D grown with the second growth plane 13B, being a {1-100} plane, as a growth plane (m-plane growth proportion) is minimized. As a result, it is possible to reduce the diameter required of the epitaxial growth layer 13 for manufacturing a GaN substrate 20 of a predetermined diameter.

As described above, the off-axis angle of the major surface 12A of the starting substrate 12 with respect to a {1-100} plane is 46.8° or smaller. For this reason, it is possible to reduce the thickness of the epitaxial growth layer 13 that is required in order to pick out a GaN substrate 20 having the *m* plane as the major surface 20A. Additionally, by using the above-noted starting substrate 12, it is possible to minimize the mixed presence in the first growth plane 13A of a plane having an off-axis angle of 62° or smaller with respect to the c plane. Doing this minimizes the mixed-in presence in-plane of regions where, compared to the other regions, the amount of captured oxygen is small and the electrical resistance is large. As a result, it is possible to minimize the occurrence of an electrical resistance distribution within the plane of the GaN substrate 20.

As described above, according to the method of manufacturing a GaN substrate in the present embodying mode, polycrystalline growth is minimized to enable efficient manufacture of GaN substrates having an *m* plane as the major surface.

In the method of manufacturing a GaN substrate in the above-noted aspect, it is preferable that the off-axis angle of the major surface 12A of the starting substrate 12 be 9.1° or greater and 20.5° or smaller with respect to a {1-100} plane.

Doing this makes it possible all the more reliably to keep polycrystalline regions from arising in the first growth region 13C. It is also possible to make the thickness required of the epitaxial growth layer 13 even smaller, while further avoiding the diameter required of the epitaxial growth layer 13 becoming excessively large.

### Embodying Mode 2

Next, Embodying Mode 2, which is another mode of embodying the present invention, will be described. The method for manufacturing a GaN substrate, which is a nitride semiconductor substrate of Embodying Mode 2 is basically embodied in the same manner as the above-described Embodying Mode 1. A GaN substrate manufacturing of Embodying Mode 2, however, differs from Embodying Mode 1 as to the arrangement of the starting substrate.

That is, referring to Fig. 1, in the method of manufacturing a GaN substrate of the second embodying mode, step S10 and step S20 are first performed similarly to the first embodying mode. When this is done, at step S20, a plurality of starting substrates are picked out.

Next, at step S30, as shown in Fig. 5, the plurality of starting substrates 12 are disposed in such a way that corresponding lateral surfaces thereof oppose each other. More specifically, in step S30, the plurality of starting substrates 12 are tiled so that the lateral surfaces are in contact with each other, and so that their major surfaces 12A constitute a single plane. In Fig. 5, α indicates the [1-100] direction, β indicates, for example, the [20-21] direction, γ indicates the [11-20] direction, and δ indicates the [0001] direction. After that, at step S40 an epitaxial growth layer 13 is grown, as is done in Embodying Mode 1, on the major surfaces 12A of the plurality of starting substrates 12 laid down in step S30. After that, step S50 is performed in the same manner as in the first embodying mode.

According to the method of manufacturing a GaN substrate according to the present embodying mode, by adopting a process of laying down a plurality of starting substrates 12 and growing an epitaxial growth layer 13 on the major surfaces 12A of the plurality of starting substrates 12, it is easy to manufacture a large-diameter GaN substrate 20.

### Embodying Mode 3

Next, Embodying Mode 3, which is yet a different mode of embodying the present invention, will be described. The method of manufacturing a GaN substrate, which is a nitride semiconductor substrate according to Embodying Mode 3 is basically performed in the same manner as the above-noted first embodying mode. Embodying Mode 3 of manufacturing a GaN substrate, however, differs from that of Embodying Mode 1 as to the plane orientation of the starting substrate. According to Embodying Mode 3, shown in Fig. 3 and Fig. 4, α indicates the [11-20] direction, β indicates, for example, the [11-21] direction, γ indicates the [1-100] direction, and δ indicates the [0001] direction.

Referring to Fig. 1, in step S10 of the third embodying mode, a GaN crystal 1 is fabricated in the same manner as in the first embodying mode. Next, at step S20, the starting substrate 12 is picked out so as to have a major surface having an off-axis angle with respect to a {11-20} plane of 4.8°C or greater and 43.7°C or smaller.

Next, after performing step S30 in the same manner as in the first embodying mode, at step S40, similar to the first embodying mode, an epitaxial growth layer 13 made of GaN is caused to grow, using HVPE. When this is done, the epitaxial growth layer 13 includes a first growth region 13C grown with the first growth plane 13A (major growth plane) that is parallel to the major surface 12A of the starting substrate 12 as its growth plane, and a second growth region 13D, as an *a*-plane growth portion, grown with the second growth plane 13B, which is a {11-20} plane, as its growth plane.

Next, at step S50, as shown in Fig. 3 and Fig. 4, of the epitaxial growth layer 13 formed in step S40, by slicing the first growth region 13C on the slicing plane 19 along the *a* plane, it is possible to obtain a GaN substrate 20 having the *a* plane as the major surface 20A. By the above-noted procedure, it is possible manufacture a GaN substrate 20 of the present embodying mode.

In the method for manufacturing a GaN substrate according to the above-noted embodying mode, as described above, the off-axis angle of the major surface 12A of the starting substrate 12 is 4.8° or greater with respect to a {11-20} plane. For this reason, the appearance of a {11-20} plane in the first growth plane 13A that is parallel to the major surface 12A of the starting substrate 12 is minimized. As a result, in the first growth region 13C that is grown with the first growth plane 13A as the growth plane in step S40, polycrystalline growth is minimized to control the occurrence of polycrystalline regions to a minimum. Also, growth at a high growth rate is possible. Additionally, the proportion of the second growth region 13D that is grown with the second growth plane 13B, which is a {11-20} plane, as the growth plane that occupies the epitaxial growth layer 13 (the *a*-plane growth proportion) is minimized. As a result, it is possible to reduce the diameter of the epitaxial growth layer 13 required to manufacture a GaN substrate 20 of the predetermined diameter.

As described above, the off-axis angle of the major surface 12A of the starting substrate 12 with respect to a {11-20} plane is 43.7° or smaller. For this reason, it is possible to reduce the thickness of the epitaxial growth layer 13 required in order to pick out a GaN substrate 20 having the a plane as the major surface 20A. Additionally, by using the above-noted starting substrate 12, it is possible to minimize the mixed presence in the first growth plane 13A of a plane having an off-axis angle of 62° or smaller with respect to the c plane. Doing this minimizes the mixed-in presence in-plane of regions where, compared to the other regions, the amount of captured oxygen is small and the electrical resistance is large. As a result, it is possible to keep the occurrence of a distribution of electrical resistance within the plane of the GaN substrate 20 under control.

As noted above, according to the method of manufacturing a GaN substrate of the present embodying mode, it is possible to manufacturer a GaN substrate having the *a* plane as the major surface with good efficiency, while minimizing polycrystalline growth.

In this case, in the method of manufacturing a GaN substrate of the above-noted embodying mode, it is preferable that the off-axis angle of the major surface 12A of the starting substrate 12 be 7.7° or greater and 32.6° or smaller with respect to a {11-20} plane.

By doing this, it is possible to keep the occurrence of polycrystalline regions in the first growth region 13C under control all the more reliably. It is also possible to make the thickness required of the epitaxial growth layer 13 even smaller, while further avoiding the diameter required of the epitaxial growth layer 13 becoming excessively large.

Although in the above-described Embodying Mode 3 the description is for the case in which a single starting substrate 12 is used, such as in Embodying Mode 1, referring to Fig. 5, a process may be adopted in which a plurality of starting substrates 12 are laid together, such as in Embodying Mode 2. In this case, in Fig. 5, α in indicates the [11-20] direction, β indicates, for example, the [11-21] direction, γ indicates the [1-100] direction, and δ indicates the [0001] direction.

### Example 1

Assuming that a GaN substrate in which the *m* plane is the major surface is cut out, an experiment was performed to form an epitaxial growth layer made of GaN on the starting substrate while varying the plane orientation of the major surface. The results of the experiment are shown in Table I.

**Table I**

| | Comp. Ex. 1 | Comp. Ex. 2 | Comp. Ex. 3 | Pres.Invent. Ex. 1 | Pres.Invent. Ex. 2 | Pres Invent. Ex. 3 | Pres Invent. Ex. 4 | Pres-Invent. Ex. 5 | Pres Invent Ex. 6 | Pres.invent. Ex. 7 | Pres Invent Ex. 8 | Comp. Ex. 4 |
|---|---|---|---|---|---|---|---|---|---|---|---|---|
| Type of growth | HVPE | HVPE | HVPE | HVPE | HVPE | HVPE | HVPE | HVPE | HVPE | HVPE | HVPE | HVPE |
| Direction of cutting substrate | m | m | m | m | m | m | m | m | m | m | m | m |
| Starting substrate major surface | (10 -10) | (90 -91) | (80-81) | (60-61) | (50-51) | (40-41) | (30-31) | (20-21) | (30-32) | (10-11) | (10-12) | (10-13) |
| 0ff-axis angle (°) with respect to m-plane | 0 | 3.4 | 3.8 | 5.1 | 6.1 | 7.6 | 10.1 | 14.9 | 19.5 | 28 | 46.8 | 57.9 |
| 0ff-axis angle (°) with respect to c-plane | 90 | 86.6 | 86.2 | 84.9 | 83.9 | 82.4 | 79.9 | 75.1 | 70.5 | 62 | 43.2 | 32.1 |
| Semiconductor layer growth plane | (10-10) | (10-10) (90-91) (80-81) (70-71) (60-61) (50-51) (50-51) (40-41) (30-31) (20-21) (10-11) | (10-10) (90-91) (80-81) (70-71) (60-61) (50-51) (40-41) (30-31) (20-21) (10-11) | (90-91) (80-81) (70-71) (60-61) (50-51) (40-41) (30-31) (20-21) (10-11) | (90-91) (80-81) (70-71) (60-61) (50-51) (40-41) (30-31) (20-21) (10-11) | (90-91) (80-81) (70-71) (60-61) (50-51) (40-41) (30-31) (20-21) (10-11) | (60-61) (50-51) (40-41) (30-31) (20-21) (10-11) | (60-61) (50-51) (40-41) (30-31) (20-21) (10-11) | (60-61) (50-51) (40-41) (30-31) (20-21) (10-11) | (60-61) (50-51) (40-41) (30-31) (20-21) (10-11) (10-12) | (60-61) (50-51) (40-41) (30-31) (20-21) (10-11) (10-12) (10-13) | (60-61) (50-51) (40-41) (30-31) (20-21) (10-11) (10-12) (10-14) |
| Required thickness (mm) | - | 3.0 | 3.3 | 4.4 | 5.3 | 6.6 | 8.8 | 12.9 | 16.7 | 23.5 | 36.4 | 42.4 |
| Cracking present? | Yes | No | No | No | No | No | No | No | No | No | No | No |
| m-plane growth proportion | 1 | 0.75 | 0.67 | 0.5 | 0.42 | 0.33 | 0.25 | 0.17 | 0.08 | 0.08 | 0.04 | 0.02 |
| In-plane polycrystalline region occurrences (no.) | 50 | 38 | 34 | 25 | 21 | 17 | 13 | 8 | 4 | 4 | 2 | 1 |
| Required diameter (mm) | - | 200.0 | 151.5 | 100.0 | 86.2 | 74.6 | 66.7 | 60.0 | 54.3 | 54.3 | 52.1 | 51.0 |

In Table I, the term "Semiconductor layer growth plane" indicates the plane orientation of the growth plane exhibited in the first growth plane 13A when the first growth plane 13A (refer to Fig. 3) that is parallel to the major surface 12A of the starting substrate 12, which is the main growth plane, is viewed microscopically. The term "Required thickness" indicates the thickness of the epitaxial growth layer required in order to pick out a 2-inch-diameter GaN substrate having the *m* plane as the major surface. The term "Cracking presence" indicates the existence or non-existence of cracks in the epitaxial growth layer. The term "*m*-plane growth proportion" indicates the ratio of the region grown with the *m* plane as the major surface occupying the epitaxial growth layer. The term "In-plane polycrystalline region occurrences" indicates the number of occurrences of a polycrystalline region in the epitaxial growth layer. The term "Required diameter" indicates the diameter of the epitaxial growth layer required in order to pick out a 2-inch-diameter GaN substrate having the *m* plane as the major surface.

Referring to Table I, in the comparison examples 1 to 3, in which the off-axis angle of the major surface of the starting substrate with respect to a {1-100} plane is smaller than 4.1°, the (10-10) plane appeared in the growth plane. For this reason, there were many occurrences of a polycrystalline region. Also, because of a high *m*-plane growth proportion, the required diameter was also large. In contrast, in the comparison example 4, in which the off-axis angle with respect to a {1-100} plane of the major surface of the starting substrate exceeded 47.8°, the required thickness was 37 mm or greater and, considering mass production processes, this is unrealistic. In contrast, in the present examples 1 to 8, in which the off-axis angle of the major surface of the starting substrate with respect to a {1-100} plane of was 4.1° or greater and 47.8° or smaller, because the (10-10) plane does not appear in the growth plane, in addition to minimizing the number of occurrences of polycrystalline regions, because the m-plane growth proportion is also made small, the required diameter is small and also the required thickness is minimized. From the above-noted results, it was verified that, in the case of manufacturing (cutting out) a GaN substrate having the *m* plane as the major surface, it is preferable that the off-axis angle of the major surface of the starting substrate with respect to a {1-100} plane be 4.1° or greater and 47.8° or smaller.

### Example 2

Assuming that a GaN substrate in which the *a* plane is the major surface is cut out, an experiment was performed to form an epitaxial growth layer made of GaN on the starting substrate while varying the plane orientation of the major surface. The results of the experiment are shown in Table II.

**Table II**

| | Comp. Ex. 1 | Comp. Ex. 2 | Comp. Ex. 3 | Pres.Invent. Ex. 1 | Pres.Invent. Ex. 2 | Pres.Invent. Ex. 3 | Pres.Invent. Ex. 4 | Pres.Invent. Ex. 5 | Pres.Invent. Ex. 6 | Comp. Ex. 4 |
|---|---|---|---|---|---|---|---|---|---|---|
| Type of growth | HVPE | HVPE | HVPE | HVPE | HVPE | HVPE | HVPE | HVPE | HVPE | HVPE |
| Direction of cutting substrate | a | a | a | a | a | a | a | a | a | a |
| Starting substrate major surface | (11-20) | (88-161) | (55-101) | (33-61) | (22-41) | (11-21) | (22-43) | (11-22) | (11-23) | (11-24) |
| Off-axis angle (°) with respect to a-plane | 0 | 2.2 | 3.5 | 5.8 | 8.7 | 17.1 | 24.7 | 31.6 | 42.7 | 50.9 |
| Off-axis angle (°) with respect to c-plane | 90 | 87.8 | 86.5 | 84.2 | 81.3 | 72.9 | 65.3 | 58.4 | 47.3 | 39.1 |
| Semiconductor layer growth plane | (11-20) | (11-20) (88-161) (55-101) (33-61) (22-41) (11-21) (11-22) (11-23) (11-24) | (11-20) (88-161) (55-101) (33-61) (22-41) (11-21) (11-22) (11-23) (11-24) | (88-161) (55-101) (33-61) (22-61) (11-21) (11-22) (11-23) (11-24) | (88-161) (55-101) (33-61) (22-61) (11-21) (11-22) (11-23) (11-24) | (55-101) (33-61) (22-41) (11-21) (11-22) (11-23) (11-24) | (55-101) (33-61) (22-41) (11-21) (11-22) (11-23) (11-24) | (55-101) (33-61) (22-41) (11-21) (11-22) (11-23) (11-24) | (33-61) (22-41) (11-21) (11-22) (11-23) (11-24) | (22-41) (11-21) (11-22) (11-23) (11-24) (11-25) |
| Required thickness (mm) | - | 1.9 | 3.1 | 5.1 | 7.6 | 14.7 | 20.9 | 26.2 | 33.9 | 38.8 |
| Cracking present? | Yes | No | No | No | No | No | No | No | No | No |
| a-plane growth proportion | 1 | 0.75 | 0.67 | 0.5 | 0.33 | 0.16 | 0.11 | 0.08 | 0.05 | 0.04 |
| In-plane polycrystalline region occurrences (no.) | 50 | 38 | 34 | 25 | 17 | 8 | 6 | 4 | 3 | 2 |
| Required diameter (mm) | - | 200.0 | 151.5 | 100.0 | 74.6 | 59.5 | 56.2 | 54.3 | 52.6 | 52.1 |

In Table II, the term "Semiconductor layer growth plane" indicates the plane orientation of the growth plane exhibited in the first growth plane 13A when the first growth plane 13A (refer to Fig. 3) that is parallel to the major surface 12A of the starting substrate 12, which is the main growth plane, is viewed microscopically. The term "Required thickness" indicates the thickness of the epitaxial growth layer required in order to pick out a 2-inch-diameter GaN substrate having the *a* plane as the major surface. The term "Cracking presence" indicates the existence or non-existence of cracks in the epitaxial growth layer. The term "*a*-plane growth proportion" indicates the ratio of the region grown with the *a* plane as the major surface occupying the epitaxial growth layer. The term "In-plane polycrystalline region occurrences" indicates the number of occurrences of a polycrystalline region in the epitaxial growth layer. The term "Required diameter" indicates the diameter of the epitaxial growth layer required in order to pick out a 2-inch-diameter GaN substrate having the *a* plane as the major surface.

Referring to Table II, in the comparison examples 1 to 3, in which the off-axis angle of the major surface of the starting substrate with respect to a {11-20} plane is smaller than 4.8°, the (11-20) plane appeared in the growth plane. For this reason, there were many occurrences of a polycrystalline region. Also, because of a high *a*-plane growth proportion, the required diameter was also large. In contrast, in the comparison example 4, in which the off-axis angle with respect to a {11-20} of the major surface of the starting substrate exceeded 43.7°, the required thickness was 34 mm or greater and, considering mass production processes, this is unrealistic. In contrast, in examples 1 to 6, in which the off-axis angle of the major surface of the starting substrate with respect to a {11-20} plane was 4.8° or greater and 43.7° or smaller, because the (11-20) plane does not appear in the growth plane, in addition to minimizing the number of occurrences of polycrystalline regions, because the *a*-plane growth proportion is also made small, the required diameter is small and also the required thickness is minimized. From the above-noted results, it was verified that, in the case of manufacturing (cutting out) a GaN substrate having the *a* plane as the major surface, it is preferable that the off-axis angle of the major surface of the starting substrate with respect to a {11-20} plane be 4.8° or greater and 43.7° or smaller.

Although in the above-noted embodying mode and examples, the descriptions are with regard to a method of manufacturing a nitride semiconductor substrate, using a GaN substrate as an example, the nitride semiconductor substrate that can be manufacturing by the method of manufacturing of the present invention is not restricted in that manner, and may be applied to the manufacturing of, for example, AIGaN substrates or InGaN substrates or the like. In the present application, a {1-100} plan and a {11-20} plane encompasses all planes that are equivalent to a (1-100) plane or a (11-20) plane. For example, a {1-100} plane includes the (1-100) plane, the (10-10) plane, the (01-10) plane, the (-1100) plane, the (-1010) plane, and the (0-110) plane, which are *m* planes.

The embodying mode and examples disclosed herein are exemplary with regard to all aspects thereof, and should not be taken to be restrictive. The scope of the present invention is indicated not by the foregoing descriptions, but rather by the claims, and the intended to encompass all equivalent meanings and variations within the scope thereof.

### Industrial Applicability

The method of manufacturing a nitride semiconductor substrate of the present invention is applicable with particular advantage to a method for manufacturing a nitride semiconductor substrate with a nonpolar plane as the major surface, for which there is a need to improve production efficiency.

### Reference Signs List

- 1: GaN crystal
- 11: Growth plane
- 12: Starting substrate
- 12A: Major surface
- 13: Epitaxial growth layer
- 13A: First growth plane
- 13B: Second growth plane
- 13C: First growth region
- 13D: Second growth region
- 19: Slicing plane
- 20: GaN substrate
- 20A: Major surface

## Claims

1. A nitride semiconductor substrate manufacturing method comprising:
a step of preparing a starting substrate consisting of a nitride semiconductor and having a major surface with an off-axis angle of between 4.1°and 47.8° inclusive with respect to a {1-100} plane;
a step of epitaxially growing onto the major surface of the starting substrate a semiconductor layer consisting of a nitride semiconductor; and
a step of picking out from the semiconductor layer a nitride semiconductor substrate whose major surface is an *m* plane.

2. The nitride semiconductor substrate manufacturing method according to claim 1, wherein the off-axis angle of the major surface of the starting substrate with respect to a {1-100} plane is between 9.1°and 20.5° inclusive.

3. A nitride semiconductor substrate manufacturing method comprising:
a step of preparing a starting substrate consisting of a nitride semiconductor and having a major surface with an off-axis angle of between 4.8°and 43.7° inclusive with respect to a {11-20} plane;
a step of epitaxially growing onto the major surface of the starting substrata a semiconductor layer consisting of a nitride semiconductor; and
a step of picking out from the semiconductor layer a nitride semiconductor substrate whose major surface is an *a* plane.

4. A nitride semiconductor substrate manufacturing method according to claim 3, wherein the off-axis angle of the major surface of the starting substrate with respect to a {11-20} plane is between 7.7°and 32.6°inclusive.

5. A nitride semiconductor substrate manufacturing method according to any one of claims 1 to 4, wherein:
in the starting substrate preparation step a plurality of starting substrates is prepared; and
in the semiconductor layer epitaxial growth step, semiconductor layers are epitaxially grown onto the major surfaces of the plurality of starting substrates, disposed in such a way that corresponding lateral surfaces thereof oppose each other.
